# EUROPÄISCHE PATENTANMELDUNG

(11) **EP 1 033 909 A2**
(43) Veröffentlichungstag der Anmeldung: **06.09.2000**
(21) Anmeldenummer: 00104187.0
(22) Anmeldetag: 29.02.2000
(51) Int. Cl.: H05K 1/14, H05K 7/14

(54) **Erschütterungen dämpfende Befestigungsanordnung**

(30) Priorität: 03.03.1999 DE 19909198
(71) Anmelder: ROBERT BOSCH GMBH, 70442 Stuttgart (DE)
(72) Erfinder: Lippok, Ralf, 71522 Backnang (DE)

(57) **Zusammenfassung**

Erschütterungen dämpfende Befestigungsanordnung zur Befestigung einer Leiterplatte (4), die ein erschütterungsempfindliches Bauelement (5) (beispielsweise Quarz) trägt, in einer Aussparung einer Trägerleiterplatte (3), wobei die Leiterplatte zwischen dämpfenden Kunststoffteilen (9, 10) eingespannt ist, die sich an einem Gehäuse (1, 2) abstützen.
Zur Vereinfachung des Aufbaus sind Kunststoffteile (9, 10) vorgesehen, die zwischen dem Rand der Leiterplatte (4) und dem Rand der Aussparung eingespannt sind. Die Kunststoffteile weisen jeweils zwischen zwei Rumpfteilen eine Einschnürung auf, die den Rand der Leiterplatte (4) und den Rand der Aussparung umgreift. Ein Rumpfteil ist an seinem freien Ende soweit verjüngt, dass dieses durch den Spalt zwischen dem Rand der Leiterplatte und dem Rand der Aussparung gezogen werden kann.

## Beschreibung

### Stand der Technik

Die Erfindung geht von der Gattung aus, wie im unabhängigen Anspruch 1 angegeben.

Es ist üblich, einen Quarz für einen Osszilator auf einer Leiterplatte anzuordnen, die in einer Aussparung einer Trägerleiterplatte gehalten wird. Dabei sind Kunststoffteile aus Schaumstoff vorgesehen, welche die Abstützung innerhalb eines Gehäuses übernehmen und zugleich dafür sorgen, dass Schwingungen und Schock nicht vollständig auf den Quarz übertragen werden können. Auf diese Weise können Beschädigungen des Quarzes vermieden werden.

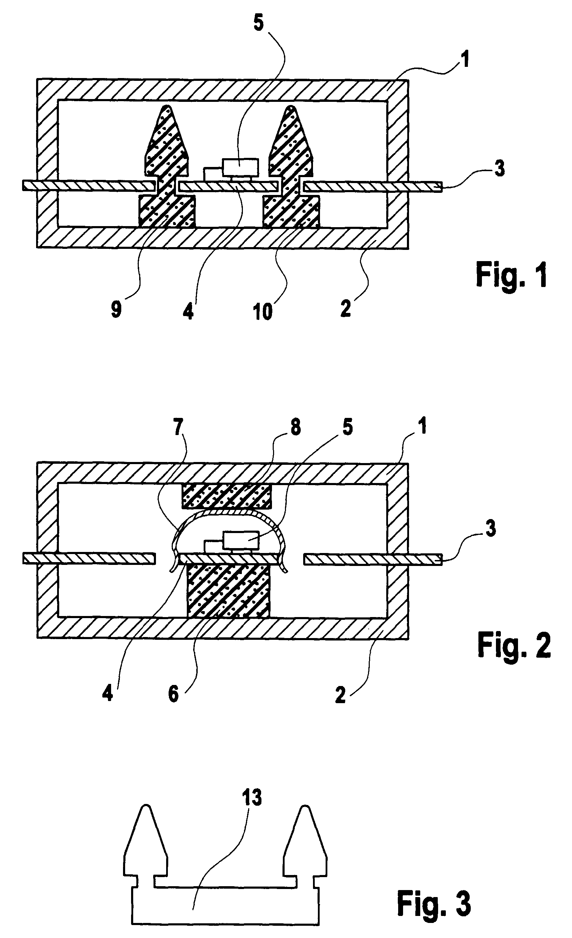

In Figur 2 ist eine solche übliche Anordnung schematisch im Querschnitt gezeigt. In einem Gehäuse mit Oberschale 1 und Unterschale 2 befindet sich in einer Aussparung einer Trägerleiterplatte 3 eine Leiterplatte 4 mit Oszillator und Quarz-Baustein 5. Ein Bügel 7 wölbt sich über den Quarz-Baustein. Die Leiterplatte 4 mit dem Bügel 7 ist als Einheit über Schaumstoffteile 6 und 8 zwischen die Gehäuseteile 1 und 2 eingespannt. Das Schaumstoffteil 6 ist entweder auf die Leiterplatte 4 oder auf die Unterschale 2 geklebt. Das Schaumstoffteil 8 ist an die Oberschale 1 oder den Bügel 7 geklebt. Die Leiterplatte ist zwischen den Gehäuseteilen 1 und 2 verschraubt.

Nachteilig ist bei dieser Befestigungsart, dass der Montageaufwand (Klebestellen reinigen, kleben, Bügel aufsetzen) hoch ist, dass die Haltbarkeit der Klebestellen beschränkt ist und dass für die Reinigung der Klebestellen unerwünschte Chemikalien verwendet werden müssen, wobei auch giftige Dämpfe entstehen können.

### Vorteile der Erfindung

Der Anmeldungsgegenstand mit den Merkmalen des Anspruches 1 hat folgenden Vorteil:

Durch die Erfindung ist die Montage vereinfacht. Es wird nur noch eine Art von Zusatzteil benötigt (der Bügel kann entfallen).

Vorteilhafte Weiterbildungen sind in den abhängigen Ansprüchen angegeben, deren Merkmale auch, soweit sinnvoll, miteinander kombiniert werden können.

Das bevorzugt aus Schaumstoff bestehende Kunststoffteil kann bevorzugt durch Abschneiden von einem Profilstrang hergestellt werden. Es ist aber auch möglich, das Kunststoffteil als rundes Spritzteil herzustellen.

### Zeichnung

Ein Ausführungsbeispiel der Erfindung ist in der Zeichnung dargestellt und im Folgenden näher erläutert. Im Wesentlichen gleiche Teile in unterschiedlichen Figuren sind mit gleichen Bezugszeichen versehen. Schematisch ist gezeigt in
Figur 1: ein Schnitt durch eine Befestigungsanordnung nach der Erfindung,
Figur 2: eine Befestigungsanordnung nach dem Stand der Technik,
Figur 3: ein Kuststoffteil mit Merkmalen nach der Erfindung,
Figur 4: eine vergrößerte perspektivische Darstellung von Teilen der Figur 1,
Figur 5 bis 7: Montagezustände eines Kunststoffteiles.
Figur 8: ein Kunststoffteil in abgewandelter Gestalt.

Im Wesentlichen gleiche Teile in unterschiedlichen Figuren sind mit gleichen Bezugszeichen versehen.

### Beschreibung des Ausführungsbeispiels

Figur 1 zeigt die schon oben im Zusammenhang mit Figur 2 beschriebenen Bestandteile einer Befestigungsanordnung nach der Erfindung, nämlich eine Oberschale 1 und eine Unterschale 2 eines Gehäuses, zwischen denen eine Trägerleiterplatte 3 befestigt ist. In einer Ausnehmung dieser Trägerleiterplatte 3 ist mittels Kunststoffteilen 9 und 10 eine Leiterplatte 4 mit einem Bauelement 5 in Gestalt eines Quarzes eingespannt. Jedes der dämpfenden Kunststoff teile 9, 10 stützt sich an den Gehäuseteilen 1 und 2 ab. Jedes der Kunststoffteile 9, 10 weist zwischen einem oberen und einem unteren Rumpfteil eine Einschnürung auf, die auf der einen Seite den Rand der Leiterplatte 4 und auf der anderen Seite den Rand der Aussparung in der Trägerleiterplatte 3 umgreift, so dass die Kunststoffteile 9 und 10 an ihren Einschnürungen im Spalt zwischen der Leiterplatte 4 und der Trägerleiterplatte 3 eingespannt sind.

Der obere Rumpfteil der Kunststoffteile 9 und 10 verjüngt sich jeweils soweit, dass er durch den Spalt zwischen dem Rand der Leiterplatte 4 und dem Rand der Aussparang in der Trägerleiterplatte 4 gezogen werden kann.

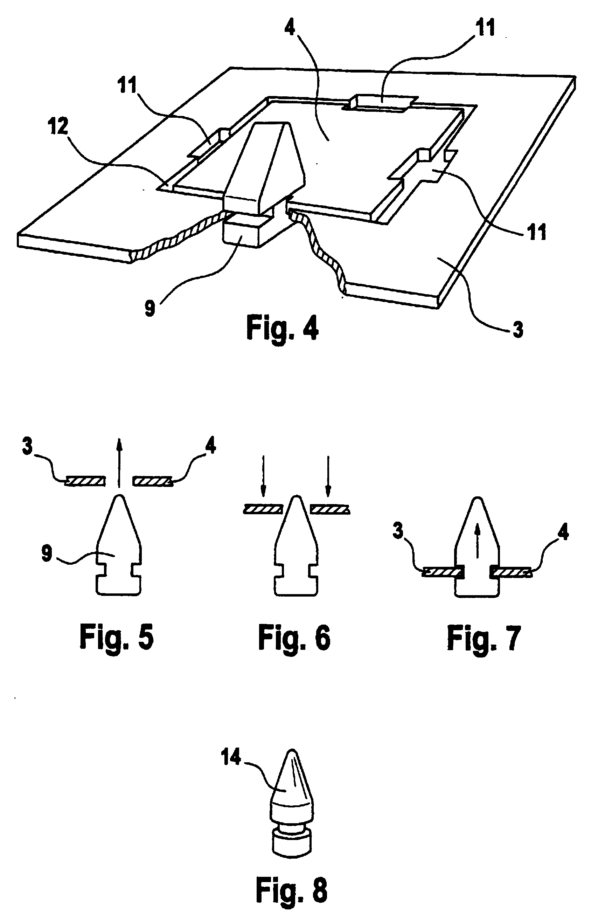

Die Figuren 5 bis 7 verdeutlichen die Montageschritte: Der verjüngte, obere Rumpfteil des Kunststoffteiles 9 wird gemäß Figur 5 zunächst in Pfeilrichtung in den Spalt zwischen 3 und 4 eingeführt. Dann greift die Montageperson das verjüngte Ende des Kunststoffteiles 9 (siehe Pfeil in Figur 6) und zieht es gemäß Figur 7 in Pfeilrichtung durch den Spalt zwischen der Trägerleiterplatte 3 und der Trägerleiterplatte 4.

Die perspektivische Darstellung in Figur 4 weist auf eine Weiterbildung hin. Dort weist der Spalt 12 zwischen der Leiterplatte 4 und der Trägerleiterplatte 3 Verbreiterungen 11 auf, die jeweils für ein Kunststoffteil 9 vorgesehen sind. Durch diese Verbreiterungen 11 ist sichergestellt, dass die jeweiligen Kunststoffteile 9 auch seitlich in der richtigen Position gehalten werden.

Zwei einander gegenüberliegende Kunststoffteile 9, 10 (vergleiche Figur 1) können gemäß Figur 3 durch einen Steg 13 einstückig miteinander verbunden sein. Das vereinfacht die Handhabung. Wenn der Steg stört, kann er aufgetrennt werden, so dass dann jedes Kunststoffteil einzeln verwendet werden kann. Dies vereinfacht die Lagerhaltung.

Die beispielsweise in den Figuren 5 bis 7 dargestellte Kunststoffteile können von einem Profilstrang abgeschnitten werden. Gemäß Figur 8 ist es aber auch möglich, ein Kunststoffteil 14 als rundes Spritzteil herzustellen. Die Verbreiterungen 11 in Figur 4 sind dann entsprechend anzupassen.

Als Werkstoff eignet sich Polyuretan-Schaumstoff, kunstharzimprägniert.

## Patentansprüche

1. Erschütterungen dämpfende Befestigungsanordnung zur Befestigung einer Leiterplatte (4), die ein erschütterungsempfindliches Bauelement (5) trägt, in einer Aussparung einer Trägerleiterplatte (3), wobei die Leiterplatte zwischen dämpfenden Kunststoffteilen eingespannt ist, die sich an einem Gehäuse (1, 2) abstützen,
dadurch gekennzeichnet, dass
- die Kunststoffteile (9, 10) zwischen dem Rand der Leiterplatte (4) und dem Rand der Aussparung eingespannt sind,
- die Kunststoffteile jeweils zwischen zwei Rumpfteilen eine Einschnürung aufweisen, die den Rand der Leiterplatte (4) und den Rand der Aussparung umgreift,
- ein Rumpfteil an seinem freien Ende soweit verjüngt ist, dass dieses durch den Spalt zwischen dem Rand der Leiterplatte und dem Rand der Aussparung gezogen werden kann.

2. Befestigungsanordnung nach Anspruch 1,dadurch gekennzeichnet, dass das Bauelement (5) ein Quarz ist.

3. Befestigungsanordnung nach Anspruch 1 oder 2,dadurch gekennzeichnet, dass das Kunststoffteil (5) aus Schaumstoff besteht.

4. Befestigungsanordnung nach einem der vorangehenden Ansprüche,dadurch gekennzeichnet, dass sich das Kunststoffteil (5) mit beiden Rumpfteilen am Gehäuse (1, 2) abstützt.

5. Befestigungsanordnung nach einem der vorangehenden Ansprüche, dadurch gekennzeichnet, dass zwei Kunststoffteile über einen Steg (13) einstückig miteinander verbunden sind.

6. Befestigungsanordnung nach einem der vorangehenden Ansprüche, dadurch gekennzeichnet, dass der Spalt (12) zwischen dem Rand der Leiterplatte (4) und dem Rand der Aussparung dort, wo das Kunststoffteil (9) eingespannt ist, eine Verbreiterung (11) aufweist.
